**Europäisches Patentamt**

**European Patent Office**

**Office européen des brevets**

(11) Publication number: **0 121 423**
**B1**

(12) **EUROPEAN PATENT SPECIFICATION**

(45) Date of publication of patent specification: **16.08.90**

(51) Int. Cl.⁵: **G 11 C 11/40**

(21) Application number: **84302182.5**

(22) Date of filing: **30.03.84**

(54) **Word line discharge in static semiconductor memories.**

(30) Priority: **31.03.83 JP 53627/83**

(43) Date of publication of application:
**10.10.84 Bulletin 84/41**

(45) Publication of the grant of the patent:
**16.08.90 Bulletin 90/33**

(84) Designated Contracting States:
**DE FR GB**

(56) References cited:
**EP-A-0 024 853**
**EP-A-0 025 316**
**EP-A-0 070 215**
**US-A-4 366 558**

(73) Proprietor: **FUJITSU LIMITED**
**1015, Kamikodanaka Nakahara-ku**
**Kawasaki-shi Kanagawa 211 (JP)**

(72) Inventor: **Okajima, Yoshinori**
**Fujitsu Dai-3 Fujigaoka-ryo 1, Fujigaoka 2-chome**
**Midori-ku Yokohama-shi Kanagawa 227 (JP)**

(74) Representative: **Fane, Christopher Robin King**
**HASELTINE LAKE & CO. Hazlitt House 28**
**Southampton Buildings Chancery Lane**
**London, WC2A 1AT (GB)**

Courier Press, Leamington Spa, England.

**Description**

The present invention relates to word line discharge in static semiconductor memories.

Various types of static semiconductor memories (hereinafter referred to as memories or memory) have been developed and put into practical use. The present invention relates to a static memory composed of saturation type memory cells. Such memories usually employ word line discharge circuits.

The operation of the word line discharge circuit is such that each word line discharge circuit quickly absorbs electric charges stored along an associated word line during a change from a selection state to a non-selection state, thereby achieving a higher speed read/write operation in the memory.

It is well known that, in memories composed of saturation-type memory cells, the word line level sometimes rises after a change from the selection state to the non-selection state. This causes a problem wherein, due to this reoccurring rise in the word line level, a deleterious double selection of two word lines takes place simultaneously in the memory. This problem may arise whenever the word line discharge current is stopped short after the change from the selection state to the non-selection state; the word line discharge current flows at every such change of state.

According to the present invention there is provided a static semiconductor memory comprising:

a plurality of word line pairs;

a plurality of bit lines pairs;

a plurality of memory cells located at respective crossing points between the said word line pairs and the said bit line pairs, each of the said memory cells comprising a pair of mutually-identical circuitry portions, each connected between the word lines of the corresponding word line pair, each such circuitry portion including a plural-emitter transistor having a first emitter connected to one of the bit lines of the corresponding bit line pair and having a second emitter connected to one of the word lines of the corresponding word line pair, and also including a load device connected between the plural-emitter transistor and the other word line of that pair;

word line discharge circuitry, connected to the said one word line of each word line pair, for absorbing discharge current from the said one word line during changes from the selection state to the non-selection state of the word line pairs; and

control circuitry, connected to the word line discharge circuitry, for maintaining a progressive reduction of the said discharge current, rather than a sharp cut-off thereof, together with a gradual attenuation of inverse current flowing from a bit line concerned to a memory cell;

characterised in that the said control circuitry comprises a plurality of dummy memory cells, equal in number to the said word line pairs and connected respectively between the said one word lines thereof and the said word line discharge circuitry, each dummy memory cell including an auxiliary plural-emitter transistor, having a further emitter connected, via a dummy bit line of the memory, to a constant voltage source, and having a second emitter connected, via a dummy word line of the memory, to a constant current source, each dummy memory cell being similar in construction to one of the said circuitry portions.

The present applicant's prior publication EP—A—0024853 discloses a static semiconductor memory comprising: a plurality of word line pairs; a plurality of bit line pairs; a plurality of memory cells located at respective crossing points between the said word line pairs and the said bit line pairs, each of the said memory cells comprising a pair of mutually-identical circuitry portions, each connected between the word lines of the corresponding word line pair, each such circuitry portion including a plural-emitter transistor having a first emitter connected to one of the bit lines of the corresponding bit line pair and having a second emitter connected to one of the word lines of the corresponding word line pair, and also including a load device connected between the plural-emitter transistor and the other word line of that pair; word line discharge circuitry, connected to the said one word line of each word line pair, for absorbing discharge current from the said one word line during changes from the selection state to the non-selection state of the word line pairs; and control circuitry, connected to the word line discharge circuitry, for maintaining a progressive reduction of the said discharge current, rather than a sharp cut-off thereof, together with a gradual attenuation of inverse current flowing from a bit line concerned to a memory cell. A similar memory is disclosed in the present applicant's prior publication EP—A—0025316. In both EP—A—0024853 and EP—A—0025316, however, the control circuitry comprises an RC circuit.

Reference will now be made, by way of example, to the accompanying drawings, wherein:

Figure 1 is a circuit diagram representing a part of a prior art semiconductor memory;

Figure 2A is an enlarged view of two memory cells representative of the memory cells shown in Figure 1, as an explanation of the problem of double selection;

Figure 2B is a general view of a memory cell arrangement including the two memory cells shown in Figure 2A;

Figure 3 depicts waveforms of signals appearing in a semiconductor memory;

Figure 4 is a schematic diagram of a semiconductor memory embodying the present invention;

Figure 5 is an enlarged cross-sectional view of a part of a memory cell $MC_2$ shown in Figure 2A;

Figure 6 is a circuit diagram of a controller CTL of Figure 4 according to a preferred embodiment of the present invention;

Figure 7A is a circuit diagram of a control circuit CC shown in Figure 6, including a level shifter LS of Figure 6 according to a first example; and

Figure 7B is a circuit diagram of the control circuit CC shown in Figure 6, including the level shifter LS of Figure 6 according to a second example.

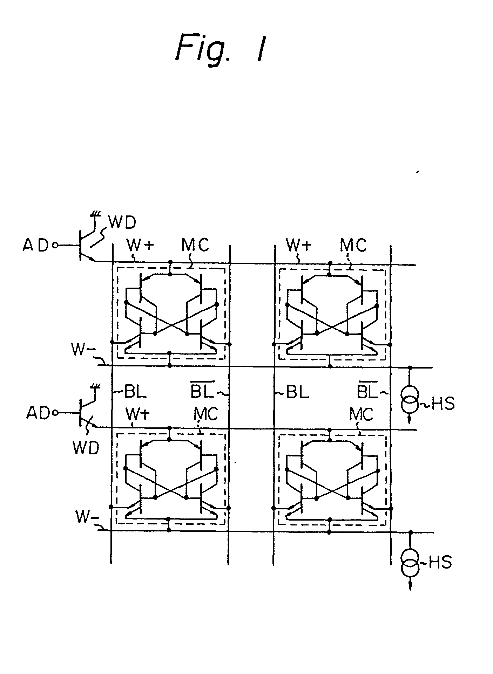

Figure 1 is a circuit diagram representing a part of a prior semiconductor memory to which the present invention can be applied. In Figure 1, characters $W_+$ and $W_-$ denote a word line pair. One end of a first word line $W_+$ is connected to a word driver WD. When an input address AD specifies one of the word drivers WD, and turns it on, the corresponding word line $W_+$ is changed to the selection state at the "H" (high) level. Following this, a selected bit line pair BL, $\overline{BL}$ is activated to access a memory cell MC, located at the cross point between the selected word line pair and the selected bit line pair, both of which bit lines BL,$\overline{BL}$ are in a selection state. Other members identical to $W_+$, $W_-$, MC, WD, BL and $\overline{BL}$ are arranged in a similar manner in the same chip of the memory device. Second word lines $W_-$ of the word line pairs are connected to respective hold current sources HS, which operate so as to hold the data of each memory cell MC as they are until the memory circuit is deenergized. In the thus constructed memory, the aforesaid deleterious double selection can often occur.

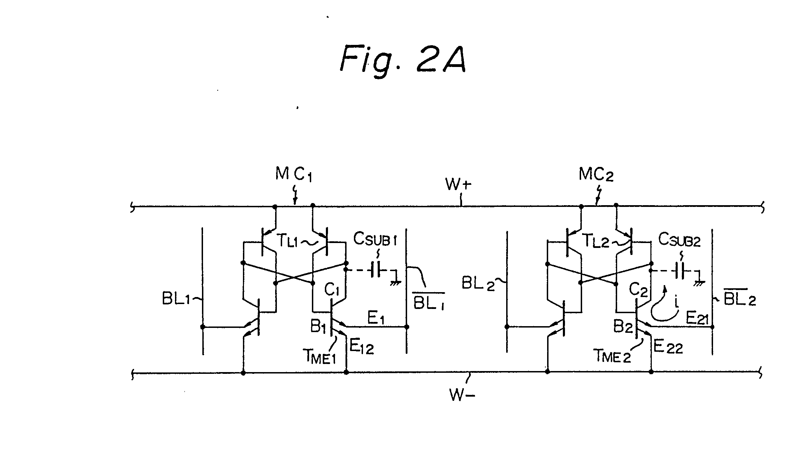

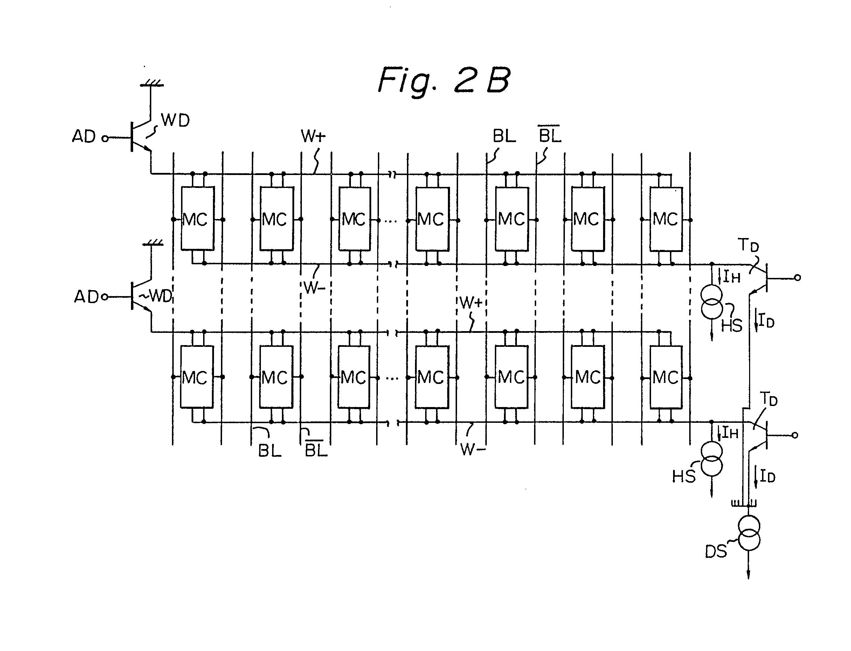

Figure 2A is an enlarged view of two memory cells, representative of the memory cells shown in Figure 1, for use in explaining the problem of double selection, and Figure 2B is a general view of a memory cell arrangement including the two memory cells shown in Figure 2A. In Figures 2A and 2B (and in other figures), members identical to those of Figure 1 are represented by the same reference characters.

In Figure 2A, let us assume that the memory cell $MC_1$ ($T_{L1}$,...) is in the selection state, and the other cell $MC_2$ ($T_{L2}$,...) is in a half-selection state. To be in the selection state means that both the word line pair and the bit line pair are activated, while the half-selection state means that only the word line pair is activated, i.e. the bit line pair is not activated. The above-mentioned double selection problem is not related to the selection memory cell $MC_1$, but to the half-selection memory cell $MC_2$. In each selected word line, the memory cells, except for one selection memory cell $MC_1$, are all half-selection memory cells $MC_2$. The following explanation will be made referring to the half-selection memory cell $MC_2$ and, specifically, to the right half of such a cell, since the left and right portions are both the same and are arranged almost symmetrically. Character $T_{L2}$ denotes a load transistor and $T_{ME2}$ a two-emitter transistor (commonly referred to as a multi-emitter transistor). The multi-emitter transistor $T_{ME2}$ has a base $B_2$, a collector $C_2$, a first emitter $E_{21}$, and a second emitter $E_{22}$. The first emitter $E_{21}$ is connected to the first bit line $\overline{BL}$, and the second emitter $E_{22}$ is connected to the second word line $W_-$. The second word line $W_-$ is used to carry both a hold current $I_H$ (see Figure 2B) from the hold circuit HS and a discharge current $iI_D$ (Figure 2B); the latter is absorbed by a word line discharge current source DS shown in Figure 2B.

The change from the selection state to the non-selection state of each word line ($W_+$, $W_-$) is quickly performed, with the aid of the discharge current $I_D$, by means of a discharge current control transistor $T_D$, shown in Figure 2B, which transistor $T_D$ is conductive during the related change of state.

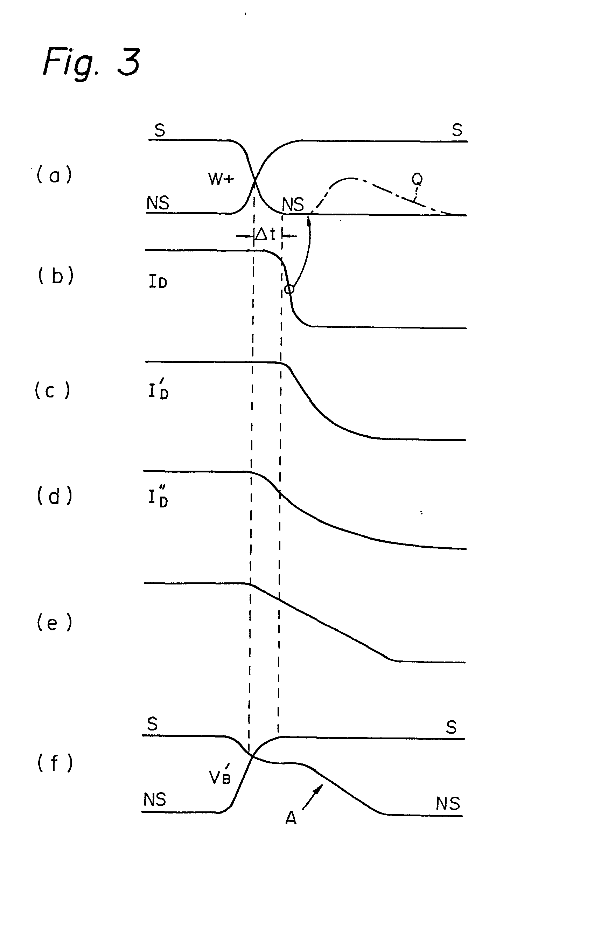

Figures 3(a) and (b) depict waveforms of the signals appearing in the memory shown in Figure 2. In Figure 3, row (a) exhibits changes in the voltage level of the word line $W_+$ when the word line changes from the selection state (referred to in the figure as S), to the non-selection state (referred to in the figure as NS), and vice versa. In this case, the voltage level of the other word line $W_-$ changes in the same way as $W_+$, i.e. corresponds to the changes at $W_+$ but the voltage level at $W_-$ is lower than that of $W_+$, by a certain amount caused by the memory cell $MC_2$. The change of the state is performed very quickly, particularly during the change from S to NS, due to the presence of the discharge current source DS (Figuce 2B). That is, the source DS largely absorbs the word line discharge current $I_D$ from the word line $W_-$ and the discharge current $I_D$ is then stopped soon (after a time $\Delta t$) after the change of the state, by a quick change from on to off state of the discharge current control transistor $T_D$ (Figure 2B). In this case, the discharge current $I_D$ changes along a curve shown in row (b).

Thereby quickly removed are the electric charges stored in the memory cells, and parasitic capacitors along the word line pair, with the flow of both currents $I_H + I_D$. These currents cause a rapid change from S to NS and, therefore, shorten the access time.

However, it is at this point that the aforementioned problem occurs, wherein the word line level rises again, as schematically illustrated by the chain-dotted line Q of row (a), owing to the sudden cessation of the word line discharge current $I_D$ a short time ($\Delta t$) after the change "S NS", as depicted in row (b). This sudden stop of the discharge current $I_D$ occurs because the word line discharge means, i.e. the transistor $T_D$ and discharge source DS of Figure 2B, form a so-called current switch as a whole. Thus, the deleterious double selection takes place due to the reoccurrence of the rise Q in level between the memory cells of one word line which changes S→NS (e.g. the upper side word line of Figure 2b) and the memory cells of another word line which changes NS→S (e.g. the lower side word line of Figure 2B). This reoccurrence of the rise Q will be explained below. Since the memory cells $MC_2$ (and also every other memory cell) is a saturation-type memory cell, the multi-emitter transistor $T_{ME2}$ is in a saturation state when it is conductive. In this saturation state, the collector ($C_2$)-base ($B_2$) junction of the transistor $T_{ME2}$ is "on" in the forward direction, and the collector voltage level $V_C$ is lower than the base voltage level $V_B$ by about 0.8 V. Thus, the NPN type transistor $T_{ME2}$ functions in a reverse mode, i.e. the transistor

$T_{ME2}$ appears to function as a reverse NPN transistor. This reverse transistor causes an inverse current i, which occurs in all of the half-selected memory cells connected to the selected word line. While the discharge current $I_D$ is supplied, however, this inverse current i is drawn through the emitter $E_{22}$. Therefore, if the discharge current $I_D$ drawn from the second emitter $E_{22}$ is stopped (refer to row (b) of Figure 3), the drawing of inverse current is adversely affected. Since the collector $C_2$ is the substrate itself, the inverse current flows into and charges the related substrate capacitor $C_{SUB2}$. Accordingly, the voltage level of the memory cell $MC_2$ is increased, as a whole, by the thus-charged voltage level. The thus-increased voltage level creates the aforesaid reoccurrence of the rise Q shown in row (a) of Figure 3. Thus, sudden cessation of the word line discharge current $I_D$, as illustrated in the curve of row (b) in Figure 3, tends to induce a significant rise Q in the level of the word line $W_+$.

To prevent this rise Q, during the inverse operation mode of the multi-emitter transistor $T_{ME2}$, the word line discharge current $I_D$ from the second emitter $E_{22}$ must not be stopped suddenly, but must be allowed to continue flowing for a while. The above-mentioned phrase, "during the inverse operation mode of the multi-emitter transistor", means that period wherein recombinations are performed in the minor carriers that thereafter disappear, which minor carriers have been stored at the base $B_2$ of the transistor $T_{ME2}$ while it was in the aforementioned saturation state. Usually the minor carriers disappear gradually, almost following the so-called logarithmic attenuation curve.

Thus, it is desirable to ensure that the word line discharge current is not stopped suddenly, as depicted in row (b) of Figure 3, but is progressively reduced according to a predetermined discharging characteristic. Examples of such discharging characteristics are depicted by the curve of row (c) in Figure 3, with a word line discharge current $I'_D$, and by the linear characteristic shown in row (e) of Figure 3. However, the applicants have found that is advantageous to use the discharging characteristic curve of row (d) in Figure 3, with a word line discharge current $I''_D$.

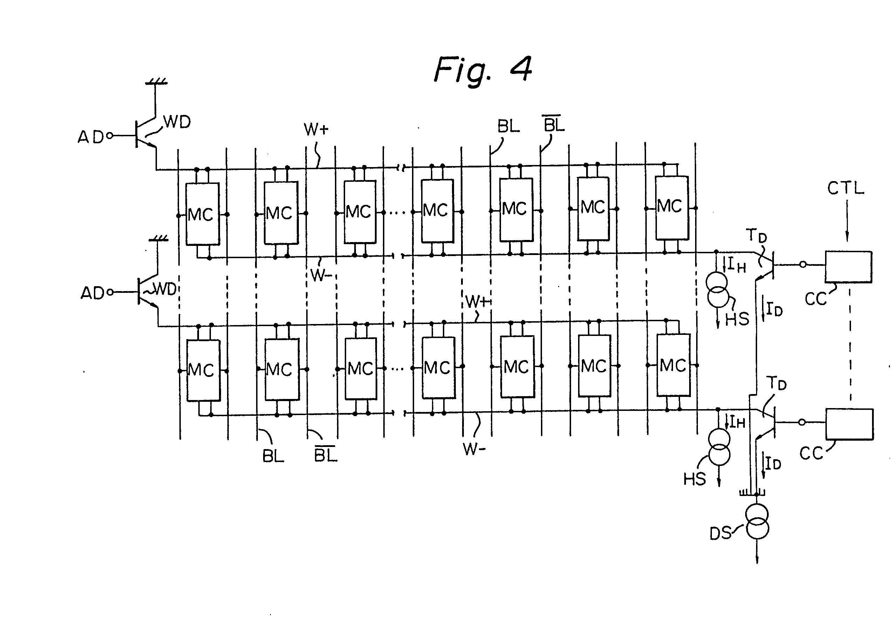

Figure 4 is a general view of a word line discharge current controller CTL in a semiconductor memory embodying the present invention, or disclosed previously in EP—A—0024853 or EP—A—0025316 for example. The controller CTL of the arrangement shown is comprised of control circuits CC connected with respective word line pairs. Each control circuit CC is operative to draw the word line discharge current, which current is decreased, during a short time after the change from the selection state to the non-selected state of the corresponding word line, together with a gradual attenuation of the aforesaid inverse current flowing from the corresponding bit line to the corresponding word line $W_-$, so as to realize a logarithmic discharging characteristic such as shown in Figure 3(d).

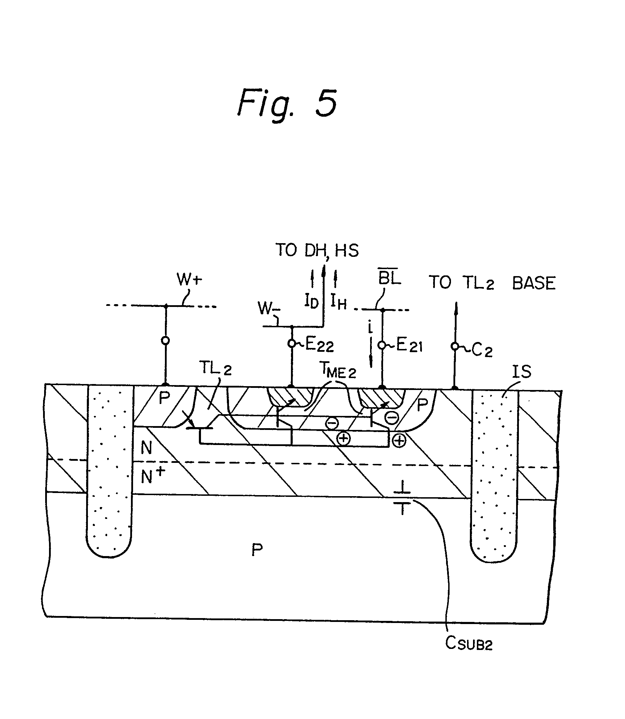

Principles of an embodiment of the invention will now be explained with reference to Figure 5, which shows an enlarged cross-sectional view of a part of the memory cell $MC_2$ shown in Figure 2A.

The emitter of the load transistor $T_{L2}$ is connected with the word line $W_+$, the collector thereof is connected with the base of the multi-emitter transistor $T_{ME2}$, and the base is connected with the collector of the transistor $T_{ME2}$. All are surrounded by an isolation IS. The word line discharge current $I_D$ is drawn from the second emitter $E_{22}$ of the transistor $T_{ME2}$ to the word line $W^-$. Since the transistor $T_{ME2}$ is saturated during the selection state, the base-collector junction of the transistor $T_{ME2}$ is made "on". Therefore, the electric charges $\oplus$ and $\ominus$ are stored separately along the border of the base-collector junction, as illustrated. In this case, the transistor $T_{ME2}$ having the emitter $E_{21}$ is operated in the aforesaid inverse operation mode and the aforesaid inverse current i flows therethrough due to the "H" level of the bit line $\overline{BL}$ and to the inverse "on" state of the transistor according to the presence of the stored charges $\oplus$, $\ominus$. The inverse current i is proportional to the sum of the currents $I_H + I_D$. When the current $I_D$ is stopped suddenly, as depicted in row (b) of Figure 3, the inverse current i can no longer be discharged with the current $I_D$, and accordingly flows into the substrate capacitor $C_{SUB2}$, which causes the aforesaid reoccurrence of the rise Q (row (a) in Figure 3). The inverse current i continues to flow until the inverse transistor having the emitter $E_{22}$ is turned off. The changes from "on" to "off" gradually advances almost in line with an advance of the recombinations of the charges $\oplus$ and $\ominus$. This change advances according to a known recombination characteristic, expressed as the following function,

$$N(t) = Ne^{-t/\tau},$$

where N denotes an initial density of the charges (time t=0), e denotes a Naperian logarithm base, and $\tau$ a time constant. Therefore, to prevent the rise Q, the discharge current $I_D$ must not be stopped suddenly, but should preferably follow the above recited function N(t). That is, the inverse current i must be further drawn toward the word line $W^-$ until, with the gradually reducing discharge current $I_D$, the stored charges disappear. In other words, the current $I_D$ must be progressively reduced together with a progressive attenuation of the inverse current flowing from the bit line BL to the word line $W^-$. Regarding the selection memory cell, such a gradual reduction of the current $I_D$ has no effect, as no inverse current i flows. This is because the selection memory cell is connected with by the bit line pair which is at the "H" (high) level.

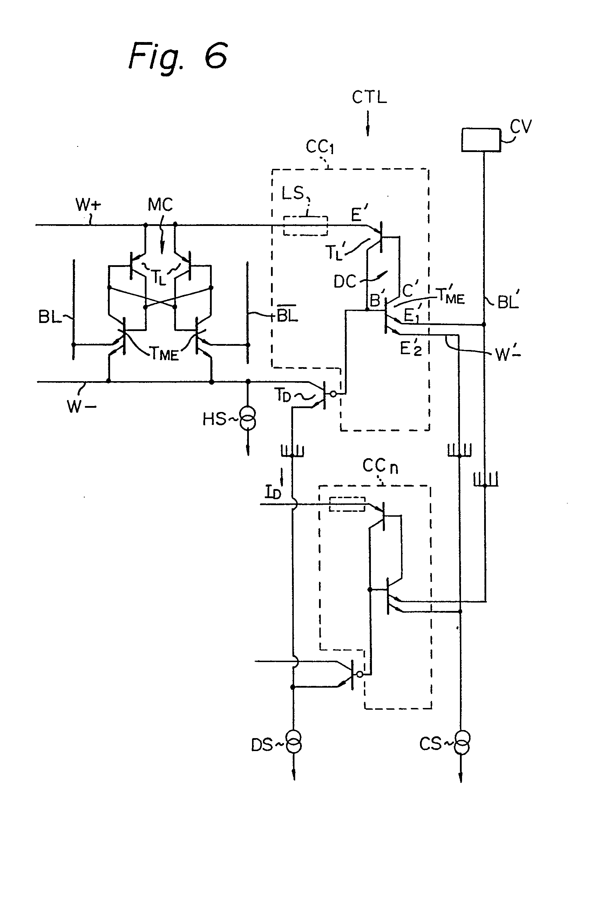

Figure 6 is a circuit diagram of the controller CTL of Figure 4 according to a preferred embodiment of the present invention. In Figure 6, only a first control circuit $CC_1$ of the controller CTL and a last control circuit $CC_n$ are shown, for simplicity, there being n word line pairs. Each control circuit has the same circuit arrangement.

Taking the upper control circuit CC₁ as being representative, this control circuit CC₁ comprises a dummy cell DC. The term "dummy" means a copy of a right (or left) half of the memory cell MC. That is, the dummy cell DC is comprised of a dummy load transistor $T_L'$ and a dummy (auxiliary) multi-emitter transistor $T_{ME}'$. The transistor $T_L'$ is connected at its dummy emitter $E'$ to the first word line $W_+$. The transistor $T_{ME}'$ is connected at its dummy first emitter $E_1'$ with a dummy bit line $BL'$ and, at its dummy second emitter $E_2'$, with a dummy second word line $W^-$. The dummy base $B'$ and the dummy collector $C'$ of the transistor $T_{ME}'$ are connected to the collector and the base of the transistor $T_L'$, respectively, the dummy base $B'$ being connected also to the base of the transistor $T_D$. CV denotes a constant voltage source, connected to the dummy bit line $BL'$, for creating a state equivalent to the state of the selected bit line. CS denotes a constant current source, connected to the dummy second word line $W_-$, for drawing a discharge current, as does the word line discharge current source DS.

The operations are as follows. The voltage level at the dummy emitter $E'$ of the dummy load transistor $T_L'$ varies together with the variation in voltage level of the first word line $W_+$. When the word line $W_+$ is selected and is at the "H" level, the dummy cell DC is active with respect to the constant current source CS. That is, the dummy cell DC is turned on. Next, when the illustrated word line pair ($W_+$, $W_-$) is not specified by the input address AD (Figure 1), the word line pair concerned is changed from the selection state to the non-selection state. During this change, the aforesaid reoccurrence of the rise Q (refer to row (a) of Figure 3) tends to take place in each of the half-selection memory cells MC pertaining to the word line pair connected. An identical rise Q tends to take place simultaneously, in the dummy cell DC. At this time, the inverse current i flows into the substrate capacitor ($C_{SUB}$) in the dummy cell DC, and also into each half-selection memory cell MC. The rise Q in the cell DC pushes the base voltage level $V_B'$ of the transistor $T_{ME}'$ upward. Such an irregular rise of $V'B$ is depicted as a step-like waveform A in row (f) of Figure 3. In this case, the discharge current control transistor $T_D$ is fully biased by the thus-increased voltage level $V_B'$, and, accordingly, the word line discharge current $I_D$ continues to flow through the transistor $T_D$ which is still maintained on by the biasing voltage $V_B'$. Here, it is important to note that the voltage level $V_B'$ varies in accordance with the variation of the rise Q. As a result, the discharge current $I_D''$ (row (d) of Figure 3) is obtained as intended, which current $I_D''$ as the characteristic curve approximated by the previously recited function

$$N(t) = Ne^{-t/\tau}.$$

The controller CTL of Figure 6 produces the following two advantages as compared with the control circuitry employed in EP—A—0024853 and EP—A—0025316. First, as mentioned above, the waveform of the current $I_D''$ exhibits the same or close to the ideal decreasing curve defined by said N(t), and a second, the uniform capability of the gradual reduction of $I_D''$ is always maintained, regardless of differences in the production batch, as the dummy cells DC are fabricated by the same process as that of the memory cells MC to be copied.

Referring again to Figure 6, LS denotes a level shifter, indicated by chain-dotted lines. The level shifter LS assures the current draw of $I_D''$ via the control transistor $T_D$. The transistor $T_D$ cannot fully conduct the current $I_D''$ where the transistor $T_D$ operates in a saturation state. Therefore, the transistor $T_D$ is preferably operated under a nonsaturation state. The nonsaturation state can be created easily by reducing the base voltage level $V_B'$ by a certain amount. Since the level $V_B'$ is determined from the word line ($W_+$) voltage level with a voltage drop across the dummy cell DC, the level $V_B'$ can be lowered by inserting the level shifter between the word line $W_+$ and the base of the transistor $T_D$, preferably between the line $W_+$ and the dummy emitter $E'$ of the transistor $T_L'$, as illustrated.

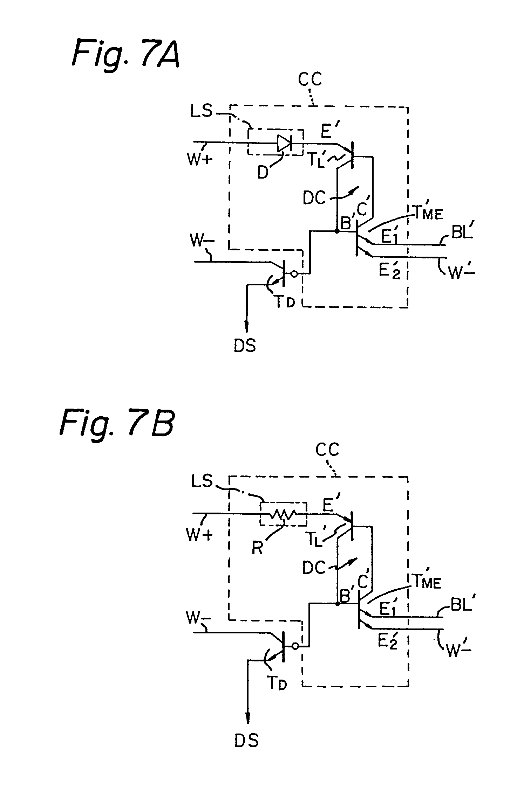

Figure 7A is a circuit diagram of the control circuit CC shown in Figure 6, including the level shifter LS of Figure 6 according to a first example. In the first example, the level shifter is composed of a diode D.

Figure 7B is a circuit diagram of the control circuit CC shown in Figure 6, including the level shifter LS of Figure 6 according to a second example. In the second example the level shifter LS is composed of a resistor R.

**Claims**

1. A static semiconductor memory comprising:
a plurality of word line pairs ($W_+$, $W^-$);
a plurality of bit line pairs (BL, $\overline{BL}$);
a plurality of memory cells (MC) located at respective crossing points between the said word line pairs ($W_+$, $W_-$) and the said bit line pairs (BL, $\overline{BL}$), each of the said memory cells (MC) comprising a pair of mutually-identical circuitry portions ($T_{L2}$, $T_{ME2}$), each connected between the word lines ($W_+$, $W_-$) of the corresponding word line pair, each such circuitry portion ($T_{L2}$, $T_{ME2}$) including a plural-emitter transistor ($T_{ME2}$) having a first emitter ($E_{21}$) connected to one of the bit lines (BL, $\overline{BL}$) of the corresponding bit line pair and having a second emitter ($E_{22}$) connected to one of the word lines ($W_-$) of the corresponding word line pair, and also including a load device ($T_{L2}$) connected between the plural-emitter transistor ($T_{ME2}$) and the other word line ($W_+$) of that pair;

word line discharge circuitry ($T_D$, Ds), connected to the said one word line ($W_-$) of each word line pair, for absorbing discharge current from the said one word line ($W_-$) during changes from the selection state to the non-selection state of the word line pairs ($W_+$, $W_-$); and

control circuit (CTL), connected to the word line discharge circuitry $(T_D, DS)$, for maintaining a progressive reduction of the said discharge current, rather than a sharp cut-off thereof, together with a gradual attenuation of inverse current flowing from a bit line (BL) concerned to a memory cell (MC);

characterised in that the said control circuitry (CTL) comprises a plurality of dummy memory cells (DC), equal in number to the said word line pairs $(W_+, W_-)$ and connected respectively between the said one word lines $(W_-)$ thereof and the said word line discharge circuitry $(T_D, DS)$, each dummy memory cell (DC) including an auxiliary plural-emitter transistor $(T'_{ME})$, having a first emitter $(E'_1)$ connected, via a dummy bit line (BL') of the memory, to a constant voltage source (CV), and having a second emitter $(E'_2)$ connected, via a dummy word line $(W'_-)$ of the memory, to a constant current source (CS), each dummy memory cell (DC) being similar in construction to one of the said circuitry portions $(T_{L2}, T_{ME2})$.

2. A memory as claimed in Claim 1, wherein each load device $(T_{L2})$ comprises a load transistor having a control terminal connected to a collector of the plural-emitter transistor $(T_{ME2})$ of the circuitry portion concerned and having its conduction path connected between the said other word line $(W_+)$ of the corresponding word line pair $(W_+, W_-)$ and a gate of the said plural-emitter transistor $(T_{ME2})$.

3. A memory as claimed in Claim 1 or 2, wherein the said control circuitry (CTL) further comprises level shifting means (LS), connected between the said other word line $(W_+)$ of each word line pair $(W_+, W_-)$ and the word line discharge circuitry $(T_D, DS)$, for effecting a predetermined voltage drop therebetween.

4. A memory as claimed in Claim 3, wherein the said level shifting means (LS) are connected between the said other word lines $(W_+)$ of each word line pair $(W_+, W_-)$ and an auxiliary load device $(T'_L)$ of each dummy memory cell (DC).

5. A memory as claimed in Claim 3 or 4, wherein the said level shifting means (LS) comprise a diode (D).

6. A memory as claimed in Claim 3 or 4, wherein the said level shifting means (LS) comprise a resistor (R).

**Patentansprüche**

1. Statischer Halbleiterspeicher mit:
einer Vielzahl von Wortleitungspaaren $(W_+, W_-)$;
einer Vielzahl von Bitleitungspaaren $(BL, \overline{BL})$;
einer Vielzahl von Speicherzellen (MC), die an entsprechenden Kreuzungspunkten zwischen den genannten Wortleitungspaaren $(W_+, W_-)$ und den genannten Bitleitungspaaren $(BL, \overline{BL})$ angeordnet sind, wobei jede der genannten Speicherzellen (MC) ein Paar von wechselseitig identischen Schaltungsabschnitten $(T_{L2}, T_{ME2})$ umfaßt, die jeweils zwischen den Wortleitungen $(W_+, W_-)$ des entsprechenden Worleitungspaares verbunden sind, jeder solcher Schaltungsabschnitt $(T_{L2}, T_{ME2})$ einen Multiemittertransistor $(T_{ME2})$ enthält, der einen ersten Emitter $(E_{21})$ hat, der mit einer der Bitleitungen $(BL, \overline{BL})$ des entsprechenden Bitleitungspaares verbunden ist und einen zweiten Emitter $(E_{22})$ hat, der mit einer der Wortleitungen $(W_-)$ des entsprechenden Wortleitungspaares verbunden ist, und auch eine Lasteinrichtung $(T_{L2})$ enthält, die zwischen dem Multiemittertransistor $(T_{ME2})$ und der anderer Wortleitung $(W_+)$ des genannten Paares verbunden ist;

einer Wortleitungs-Entladeschaltung $(T_D, DS)$, die mit der genannten einen Wortleitung $(W_-)$ von jedem Wortleitungspaar verbunden ist, um einen Entladestrom von der genannten einen Wortleitung $(W^-)$, während Änderungen von dem Auswahlzustand zu dem Nichtauswahlzustand des Worleitungspaares $(W_+, W_-)$, zu absorbieren; und

eine Steuerschaltung (CTL), die mit der Wortleitungs-Entladeschaltung $(T_D, DS)$ verbunden ist, um eine progressive Reduktion des genannten Entladestromes aufrechtzuerhalten, anstelle einer scharfen Abschneidung desselben, zusammen mit einer graduierlichen Dämpfung des inversen Stroms, der von einer betreffenden Bitleitung (BL) zu einer Speicherzelle (MC) fließt;

dadurch gekennzeichnet, daß die genannte Steuerschaltung (CTL) eine Vielzahl von Blindspeicherzellen (DC) umfaßt, deren Anzahl gleich jener der Wortleitungspaare $(W_+, W_-)$ ist, und die jeweils zwischen der genannten einen Wortleitung $(W_-)$ davon und der genannten Wortleitungs-Entladeschaltung $(T_D, DS)$ verbunden sind, wobei jede Blindspeicherzelle (DC) einen Hilfs-Multiemittertransistor $(T'_{ME})$ enthält, der einen ersten Emitter $(E'_1)$ hat, der über eine Blindbitleitung (BL') des Speichers mit einer Konstantspannungsquelle (CV) verbunden ist, und einen zweiten Emitter $(E'_2)$, der über eine Blind-Wortleitung $(W'_-)$ des Speichers mit einer Konstantstromquelle (CS) verbunden ist, wobei jede Blindspeicherzelle (DC) in ihrem Aufbau ähnlich einem der genannten Schaltungsabschnitte $(T_{L2}, T_{ME2})$ ist.

2. Speicher nach Anspruch 1, bei dem jede Lasteinrichtung $(T_{L2})$ einen Lasttransistor umfaßt, der einen Steueranschluß hat, der mit einem Kollektor des Multiemittertransistors $(T_{ME2})$ des betreffenden Schaltungsabschnittes verbunden ist, und dessen Leitungsweg zwischen der genannten anderen Wortleitung $(W_+)$ des entsprechenden Wortleitungspaares $(W_+, W_-)$ und einem Gate des genannten Multiemittertransistors $(T_{ME2})$ verbunden ist.

3. Speicher nach Anspruch 1 oder 2, bei dem die genannte Steuerschaltung (CTL) ferner Pegelschiebeeinrichtung (LS) umfaßt, die zwischen der genannten anderen Wortleitung $(W_+)$ von jedem Wortleitungspaar $(W_+, W_-)$ und der Wortleitungs-Entladeschaltung $(T_D, DS)$ verbunden sind, um einen vorbestimmten Spannungsabfall dazwischen zu bewirken.

4. Speicher nach Anspruch 3, bei dem die genannten Pegelschiebeeinrichtungen (LS) zwischen den genannten anderen Wortleitungen (W$_+$) von jedem Wortleitungspaar (W$_+$, W$_-$) und einer Hilfslasteinrichtung (T'$_L$) von jeder Blindspeicherzelle (DC) verbunden sind.

5. Speicher nach Anspruch 3 oder 4, bei dem die genannten Pegelschiebeeinrichtungen (LS) eine Diode (D) umfassen.

6. Speicher nach Anspruch 3 oder 4, bei dem die genannten Pegelschiebeeinrichtungen (LS) einen Widerstand (R) umfassen.

## Revendications

1. Mémoire statique à semiconducteur comprenant:

un ensemble de paires de fils de mot (W$_+$, W$_-$);

un ensemble de paires de fils de bit (BL, $\overline{BL}$);

un ensemble de cellules de mémoire (MC) situées aux points de croisement respectifs entre les paires de fils de mot (W$_+$, W$_-$) et les paires de fils de bit (BL, $\overline{BL}$), chacune des cellules de mémoire (MC) comprenant une paire de parties de circuits identiques entre elles (T$_{L2}$, T$_{ME2}$), chacune étant connectée entre les fils de mot (W$_+$, W$_-$) de la paire de fils de mot correspondante, chaque partie de circuits (T$_{L2}$, T$_{ME2}$) incluant un transistor à plusieurs émetteurs (T$_{ME2}$) comportant un premier émetteur (E$_{21}$) connecté à un des fils de bit (BL, $\overline{BL}$) de la paire de fils de bit correspondante et comportant un deuxième émetteur (E$_{22}$) connecté à un des fils de mot (W$_-$) de la paire de fils de mot correspondante, et incluant également un dispositif de chargement (T$_{L2}$) connecté entre le transistor à plusieurs émetteurs (T$_{ME2}$) et l'autre fil de mot (W$_+$) de la paire;

des circuits de décharge de fil de mot (T$_D$, DS), connectés au fil de mot (W$_-$) de chaque paire de fils de mot pour absorber le courant de décharge du fil de mot (W$_-$) pendant les passages de l'état de sélection à l'état de non-sélection des paires de fils de mot (W$_+$, W$_-$); et

des circuits de commande (CTL), connectés aux circuits de décharge de fil de mot (T$_D$, DS), pour maintenir une réduction progressive du courant de décharge, plutôt que sa coupure nette, avec une atténuation graduelle d'un courant inverse passant d'un fil de bit (BL) concerné à une cellule de mémoire (MC);

caractérisée en ce que les circuits de commande (CTL) comprennent un ensemble de cellules de mémoire fictives (DC), égales en nombre ? aux paires de fils de mot (W$_+$, W$_-$) et respectivement connectées entre les fils de mot (W$_-$) de celles-ci et les circuits de décharge de fil de mot (T$_D$, DS), chaque cellule de mémoire fictive (DC) incluant un transistor à plusieurs émetteurs auxiliaire (T'$_{ME}$), comportant un premier émetteur (E'$_1$) connecté, par l'intermédiaire d'un fil de bit fictif (BL') de la mémoire, à une source de tension constante (CV), et comportant un deuxième émetteur (E'$_2$) connecté, par l'intermédiaire d'un fil de mot fictif (W'$_-$) de la mémoire, à une source de courant constant (CS), chaque cellule de mémoire fictive (DC) ayant une construction semblable à celle des parties de circuits (T$_{L2}$, T$_{ME2}$).

2. Mémoire selon la revendication 1, dans laquelle chaque dispositif de chargement (T$_{L2}$) comprend un transistor de chargement ayant une borne de commande connectée à un collecteur du transistor à plusieurs émetteurs (T$_{ME2}$) de la partie de circuits concernée et ayant son chemin de conduction connecté entre l'autre fil de mot (W$_+$) de la paire de fils de mot correspondante (W$_+$, W$_-$) et une grille du transistor à plusieurs émetteurs (T$_{ME2}$).

3. Mémoire selon l'une quelconque des revendications 1 et 2, dans laquelle les circuits de commande (CTL) comprennent en outre des moyens décaleurs de niveau (LS), connectés entre l'autre fil de mot (W$_+$) de chaque paire de fils de mot (W$_+$, W$_-$) et les circuits de décharge de fil de mot (T$_D$, DS), pour produire une chute de tension prédéterminée entre ceux-ci.

4. Méthode selon la revendication 3, dans laquelle les moyens décaleurs deniveau (LS) sont connectés entre l'autre fil de mot (W$_+$) de chaque paire de fils de mot (W$_+$, W$_-$) et un dispositif de chargement auxiliaire (T'$_L$) de chaque cellule de mémoire fictive (DC).

5. Mémoire selon l'une quelconque des revendications 3 et 4, dans laquelle les moyens décaleurs de niveau (LS) sont constitués par une diode (D).

6. Méthode selon l'une quelconque des revendications 3 et 4, dans laquelle les moyens décaleurs de niveau (LS) sont constitués par une résistance (R).

# Fig. 1

Fig. 2A

EP 0 121 423 B1

Fig. 2B

# Fig. 3

Fig. 4

## Fig. 5

# Fig. 6

## Fig. 7A

## Fig. 7B

8